Europäisches Patentamt

European Patent Office

Office européen des brevets

(19)

(11) Veröffentlichungsnummer : **0 060 541**
**B1**

(12) **EUROPÄISCHE PATENTSCHRIFT**

(45) Veröffentlichungstag der Patentschrift :
07.11.84

(21) Anmeldenummer : 82102034.4

(22) Anmeldetag : 13.03.82

(51) Int. Cl.³ : **G 03 C   1/66**, G 03 C   1/92//
**H01J9/227**

(54) **Verfahren zur Herstellung einer Leuchtstoffsuspension.**

(30) Priorität : 18.03.81 DE 3110476

(43) Veröffentlichungstag der Anmeldung :
22.09.82 Patentblatt 82/38

(45) Bekanntmachung des Hinweises auf die Patenterteilung : 07.11.84 Patentblatt 84/45

(84) Benannte Vertragsstaaten :
**BE DE FR GB IT NL**

(56) Entgegenhaltungen :
**DE-B- 1 772 781**
**DE-B- 2 162 886**
**DE-B- 2 411 869**
**GB-A- 1 266 612**

(73) Patentinhaber : **International Standard Electric Corporation**
**320 Park Avenue**
**New York New York 10022 (US)**
**BE FR GB IT NL**
**Standard Elektrik Lorenz Aktiengesellschaft**
**Hellmuth-Hirth-Strasse 42**
**D-7000 Stuttgart 40 (DE)**
**BE DE FR GB IT NL**

(72) Erfinder : **Gerstle, Volker**
**Stettener Strasse 97**
**D-7300 Esslingen (DE)**
Erfinder : **Mauz, Gerhard**
**Unterdorfstrasse 69**
**D-7316 Köngen (DE)**
Erfinder : **Zondler, Rolf**
**Marabustrasse 26**
**D-7000 Stuttgart 50 (DE)**

(74) Vertreter : **Graf, Georg Hugo, Dipl.-Ing. et al**
**c/o Standard Elektrik Lorenz AG Patent- und Lizenzwesen Postfach 300 929 Kurze Strasse 8**
**D-7000 Stuttgart 30 (DE)**

## Beschreibung

Die Erfindung betrifft ein Verfahren zur Herstellung einer Leuchtstoffsuspension, wobei zwecks Bildung eines photoempfindlichen Filmes eine Suspension aus einem photoempfindlichen Material, einem Photosensibilisator und einem Leuchtstoff zusammengemischt wird.

Die Herstellung der Leuchtschirme für Farbbildröhren und Vakuumfluoreszenz-Displays wird heute allgemein in der Weise durchgeführt, daß man ein photoempfindliches Material und einen Photosensibilisator zusammenmischt, in das so erhaltene Flüssiggemisch einen Leuchtstoff dispergiert und diese Suspension auf die innere Oberfläche eines Schirmträgers aufbringt. Um einen lichtempfindlichen Film zu erhalten, wird dann getrocknet, dieser Film durch die Öffnungen einer Schattenmaske von der Leuchtstoffseite her, oder durch eine Photomaske durch das Frontglas belichtet und darauf der belichtete Film entwickelt. Nach diesem Verfahren erhält man eine regelmäßige Anordnung von Leuchtstoffpunkten bzw. Streifen, wobei man, um eine Dreifarben-Emission zu erhalten, jeden der zuvor angegebenen Verfahrensschritte unter Verwendung von Leuchtstoffen für eine grüne, blaue und rote Emission wiederholen muß.

Als Photosensibilisator, der der Suspension zur Bildung des photoempfindlichen Films zugesetzt wird, wird dabei z. B. nach der DE-B 21 62 886 Dichromat zugesetzt. Dieser bekannten Verfahrensweise haftet immer noch der Nachteil an, daß die Belichtungszeit zur Herstellung gleicher Leuchtstoffschichtdicken immer noch sehr lang ist, d. h. daß die Lichtempfindlichkeit noch zu gering ist. Insbesondere ist bei Vakuumfluoreszenz-Displays die Ausbildung von geschlossenen Leuchtstoffschichten, deren Haftung auf dem Untergrund und die Konturenschärfe recht mangelhaft.

Der Erfindung liegt daher nun die Aufgabe zugrunde, ein Verfahren zur Herstellung von verbesserten Leuchtstoffschichten eines Leuchtschirmes zu schaffen, wobei insbesondere eine bessere Leuchtstoffhaftung der Schichten auf dem Schirmträger und eine verbesserte Leuchtstoffkontur vorhanden ist.

Die gestellte Aufgabe wird erfindungsgemäß dadurch gelöst, daß bei der Bildung des photoempfindlichen Filmes der Leuchtstoffsuspension als Photosensibilisator eine Chromsäurelösung zugesetzt wird.

Anschließend wird dann die so erhaltene Leuchtstoffsuspension beschirmt, der genannte lichtempfindliche Film getrocknet, belichtet und entwickelt.

Als vorteilhaft hat sich dabei herausgestellt, die der Suspension als Photosensibilisator zugesetzte Chromsäurelösung als eine 0,1-15 Gew.-%ige Chromsäurelösung, insbesondere eine 5-10 Gew.-%ige Chromsäurelösung zuzusetzen.

Um eine gute Haftung und Kontur des Leuchtstoffilmes auf dem Schirmträger zu erreichen, hat es sich als vorteilhaft herausgestellt, zuerst die Lösung des photoempfindlichen Materials mit der Chromsäurelösung zu mischen und dann darin den Leuchtstoff zu suspendieren.

Als photoempfindliches Material wird dabei bevorzugterweise ein Polyvinylalkohol eingesetzt.

Nach dem Zusammenmischen des photoempfindlichen Materials mit der Chromsäurelösung wird dann der Leuchtstoff zugesetzt.

Das erfindungsgemäße Verfahren eignet sich nicht nur zur Verbesserung der Leuchtstoffhaftung und der Leuchtstoffkontur bei Farbbildröhren jeglichen Formats, sondern ist auch besonders geeignet für die Herstellung von Vakuumfluoreszenz-Displays.

Bezüglich der Farbbildröhren ist das erfindungsgemäße Verfahren sowohl für Leuchtschirme von 26″ (kleiner Q-Abstand) als auch bei 27″ (großer Q-Abstand) geeignet.

Das erfindungsgemäße Verfahren wird anhand des folgenden Beispiels zur Herstellung von Vakuumfluoreszenz-Displays noch näher erläutert.

Beispiel

Zur Bildung eines vorteilhaften Filmes wird eine Suspension aus 4 Gramm Polyvinylalkohol (10 Gew.-%), 0,24 Gramm $CrO_3$-Lösung (8 Gew.-%), 42 Gramm Leuchtstoff und 18 Gramm Demi-Wasser hergestellt.

Diese Suspension wird auf die innere Oberfläche eines Schirmträgers aufgebracht, der so gebildete Leuchtstoffilm getrocknet, in bekannter Weise belichtet und entwickelt.

Der so erhaltene Leuchtstoffilm, der eine Schichtdicke von 5-30 μm aufweist, besitzt eine gute Haftung auf dem Schirmträger, weist eine gute Füllung, d. h. eine geschlossene Schicht auf und besitzt scharfe Konturen. Bei der Belichtung des Leuchtstoffilmes ergibt sich eine Verringerung der Belichtungszeit im Vergleich zu dem bekannten Stande der Technik; so ergibt sich nämlich bei der Verwendung von Kaliumdichromat als Photosensibilisator eine Belichtungszeit von 35-40 Sec., während bei dem Einsatz von einer Chromsäurelösung eine Belichtungszeit von 10-15 Sec. gemessen wird, bei einer gleichen Schichtdicke des Leuchtstoffilmes. Dies bedeutet eine starke Erhöhung der Lichtempfindlichkeit.

Die mit der Erfindung erzielten Vorteile bestehen insbesondere darin, daß sich auf dem Schirmträger gut geschlossene Leuchtstoffilmschichten ausbilden, die eine gute Haftung auf dem Untergrund besitzen und der Leuchtstoffilm eine sehr große Konturenschärfe aufweist.

## Ansprüche

1. Verfahren zur Herstellung einer Leuchtstoffsuspension, wobei man zwecks Bildung eines photoempfindlichen Filmes eine Suspension aus einem photoempfindlichen Material, einem Photosensibilisator und einem Leuchtstoff zusammenmischt, dadurch gekennzeichnet, daß der Suspension als Photosensibilisator eine Chromsäurelösung zugesetzt wird.

2. Verfahren nach Anspruch 1, dadurch gekennzeichnet, daß die der Suspension als Photosensibilisator zugesetzte Chromsäurelösung 0,1 bis 15 Gew.-%ig ist.

3. Verfahren nach Anspruch 2, dadurch gekennzeichnet, daß die der Suspension als Photosensibilisator zugesetzte Chromsäurelösung 5 bis 10 Gew.-%ig ist.

4. Verfahren nach Anspruch 1, dadurch gekennzeichnet, daß man vor der Zugabe des Leuchtstoffes das photoempfindliche Material und die Chromsäurelösung zusammenmischt.

5. Verfahren nach den Ansprüchen 1 oder 4, dadurch gekennzeichnet, daß man als photoempfindliches Material Polyvinylalkohol einsetzt.

## Claims

1. Method of preparing a phosphor suspension by mixing a photosensitive material, a photosensitizer and a phosphor for the purpose of forming a photosensitive film, characterized in that a chromic acid solution is added to the suspension as the photosensitizer.

2. A method as claimed in Claim 1, characterized in that the percentage by weight of the chromic acid solution added to the suspension as the photosensitizer is 0.1-15 %.

3. A method as claimed in Claim 2, characterized in that the percentage by weight of the chromic acid solution added to the solution as the photosensitizer is 5-10 %.

4. A method as claimed in Claim 1, characterized in that the photosensitive material and the chromic acid solution are mixed before the phosphor is added.

5. A method as claimed in Claim 1 or 4, characterized in that the photosensitive material is polyvinyl alcohol.

## Revendications

1. Procédé de réalisation d'une suspension de luminophore pour former un film photosensible, dans lequel on réalise, par mélange, une suspension d'une matière photosensible, d'un photosensibilisateur et d'un luminophore, caractérisé en ce que l'on incorpore dans la suspension une solution d'acide chromique, en tant que photosensibilisateur.

2. Procédé selon la revendication 1, caractérisé en ce que la solution d'acide chromique incorporée en tant que photosensibilisateur est une solution à 0,1 à 15 % en poids.

3. Procédé selon la revendication 2, caractérisé en ce que la solution d'acide chromique incorporée, en tant que photosensibilisateur, à la suspension, est une solution à 5 à 10 % en poids.

4. Procédé selon la revendication 1, caractérisé en ce qu'avant l'apport luminophore, on mélange la matière photosensible et la solution d'acide chromique.

5. Procédé selon la revendication 1 ou 4, caractérisé en ce que l'on utilise, comme matière photosensible, de l'alcool polyvinylique.